(19) Europäisches Patentamt
European Patent Office
Office européen des brevets

(11) **EP 4 270 047 A1**

(12) **EUROPEAN PATENT APPLICATION**
published in accordance with Art. 153(4) EPC

(43) Date of publication:
**01.11.2023 Bulletin 2023/44**

(21) Application number: **22845967.3**

(22) Date of filing: **20.07.2022**

(51) International Patent Classification (IPC):
**G01S 7/03** (2006.01)   **H01Q 17/00** (2006.01)
**H05K 9/00** (2006.01)   **G01S 13/931** (2020.01)

(52) Cooperative Patent Classification (CPC):
**G01S 7/03; H01Q 17/00; H05K 9/00;** G01S 13/931

(86) International application number:
**PCT/JP2022/028281**

(87) International publication number:
**WO 2023/003034 (26.01.2023 Gazette 2023/04)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **21.07.2021 JP 2021121071**

(71) Applicant: **NITTO DENKO CORPORATION**
**Ibaraki-shi**
**Osaka 567-8680 (JP)**

(72) Inventors:
• **UI Takehiro**
**Ibaraki-shi, Osaka 567-8680 (JP)**
• **FUKE Kazuhiro**
**Ibaraki-shi, Osaka 567-8680 (JP)**
• **MATSUZAKI Yuya**
**Ibaraki-shi, Osaka 567-8680 (JP)**
• **AKIYAMA Kyohei**
**Ibaraki-shi, Osaka 567-8680 (JP)**

(74) Representative: **Grünecker Patent- und Rechtsanwälte**
**PartG mbB**
**Leopoldstraße 4**
**80802 München (DE)**

(54) **ELECTROMAGNETIC WAVE SHIELD**

(57) An electromagnetic shield 1a includes a plate-shaped base 5, a plurality of first projecting portions 32, and a plurality of second projecting portions 2. The plate-shaped base 5 has a first surface 10 and a second surface 20. The first surface 10 is a surface configured to allow an electromagnetic wave Ei to be incident on the first surface 10. The second surface 20 is a surface being distant from the first surface 10 and extending along the first surface 10. The plurality of first projecting portions 32 project from the first surface 10 in a direction away from the second surface 20. The plurality of second projecting portions 33 project from the second surface 20 in a direction away from the first surface 10. The electromagnetic shield 1a includes a dielectric.

FIG. 1

EP 4 270 047 A1

**Description**

TECHNICAL FIELD

The present invention relates to an electromagnetic shield.

BACKGROUND ART

Sensing systems using radio waves have been known. For example, collision avoidance systems including a radar using a radio wave with a given wavelength are under discussion in the automotive technical field. Such collision avoidance systems, for example, detect obstacles, measure the speed of nearby vehicles, measure a distance between a vehicle equipped with the system and its nearby vehicle, and then adjust the speed of the vehicle and a vehicle-to-vehicle distance. To allow a collision avoidance system to normally operate, it is important not to receive unnecessary radio waves, which make noise.

Patent Literature 1 describes the use of an electromagnetic wave absorber for absorption of unnecessary electromagnetic waves causing a driver-assistance system to malfunction. In the electromagnetic wave absorber described in Patent Literature 1, a plurality of scattering bodies made of a second dielectric material and having a particular shape are cyclically arranged in a matrix made of a first dielectric material.

Patent Literature 2 describes an obstacle detection device for vehicles, the obstacle detection device being configured to detect obstacles by allowing a radio wave from a radar device provided between a back surface of a bumper and a vehicle to pass through the bumper outward. This obstacle detection device for vehicles includes a false-detection prevention member configured to prevent the radar device from making false detections. The false-detection prevention member includes, for example, a diffused reflection structure including irregularities having a given shape (refer to FIG. 13). It is understood that the diffused reflection structure diffusely reflects an incident wave from the radar device to disperse the energy of the incident wave, thereby preventing false detections.

Patent Literature 3 describes a side shield for radar transceivers. A non-uniform delay structure is arranged over the side shield. The non-uniform delay structure delays a radar signal propagating through the side shield by a variable amount depending on the wavelength of the radar signal and a location on the side shield through which the radar signal propagates. The radar signal is thereby steered and diffused after propagation through the side shield.

CITATION LIST

Patent Literature

Patent Literature 1: JP 2004-153135 A
Patent Literature 2: JP 5696781 B2
Patent Literature 3: WO 2021/058450 A1

SUMMARY OF INVENTION

Technical Problem

Electromagnetic shielding is conceivable for prevention of reception of unnecessary radio waves. An electromagnetic shield that can exhibit such an electromagnetic shielding function may be manufactured by molding. The above patent literatures fail to give any particular discussion on electromagnetic shields from the viewpoints of electromagnetic shielding performance and ease of manufacturing by molding.

In view of such circumstances, the present invention provides an electromagnetic shield that is advantageous in electromagnetic shielding and ease of manufacturing by molding.

Solution to Problem

The present invention provides an electromagnetic shield including:

a plate-shaped base having a first surface and a second surface, the first surface being configured to allow an electromagnetic wave to be incident on the first surface, the second surface being distant from the first surface and extending along the first surface;

a plurality of first projecting portions (structure) projecting from the first surface in a direction away from the second surface; and

a plurality of second projecting portions (first projecting portions) projecting from the second surface in a direction away from the first surface, wherein

the electromagnetic shield includes a dielectric.

Advantageous Effects of Invention

The above electromagnetic shield is advantageous in electromagnetic shielding and ease of manufacturing by molding.

BRIEF DESCRIPTION OF DRAWINGS

FIG. 1 is a side view of an example of the electromagnetic shield according to the present invention.
FIG. 2 is a plan view of a first surface of the electromagnetic shield shown in FIG. 1.
FIG. 3 is a plan view of a second surface of the electromagnetic shield shown in FIG. 1.
FIG. 4 is a side view of the electromagnetic shield shown in FIG. 1 and being inclined to a horizontal plane.
FIG. 5 is a plan view of another example of the electromagnetic shield according to the present invention.
FIG. 6 is a plan view of another example of the electromagnetic shield according to the present invention.
FIG. 7 is a plan view of an example of the radar cover according to the present invention.
FIG. 8 is a cross-sectional view of the radar cover along a line VIII-VIII shown in FIG. 7.
FIG. 9 is a plan view of another example of the radar cover according to the present invention.
FIG. 10A schematically shows an example of a computation model of electromagnetic field simulation in EXAMPLES.
FIG. 10B schematically shows an example of a computation model of electromagnetic field simulation in EXAMPLES.
FIG. 10C schematically shows a portion of a computation model of electromagnetic field simulation in EXAMPLES.

DESCRIPTION OF EMBODIMENTS

Hereinafter, embodiments of the present invention will be described with reference to the drawings. The present invention is not limited to the following embodiments.

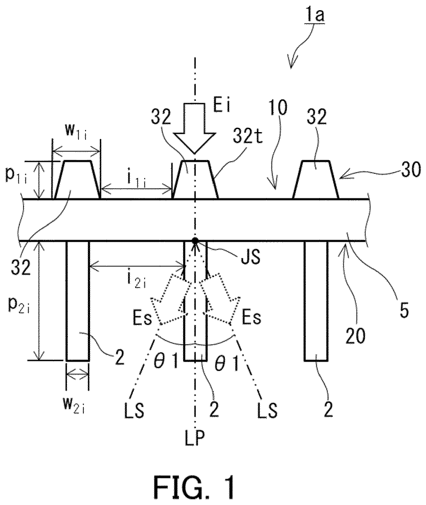

As shown in FIGS. 1, 2, and 3, an electromagnetic shield 1a includes a plate-shaped base 5, a plurality of first projecting portions 32, and a plurality of second projecting portions 2. The plate-shaped base 5 has a first surface 10 and a second surface 20. The first surface 10 is a surface configured to allow an electromagnetic wave Ei to be incident on the first surface 10. The second surface 20 is a surface being distant from the first surface 10 and extending along the first surface 10. The first projecting portions 32 project from the first surface 10 in a direction away from the second surface 20. The second projecting portions 33 project from the second surface 20 in a direction away from the first surface 10. The electromagnetic shield 1a includes a dielectric. The term "electromagnetic shield" herein refers to an article that can exhibit a function of attenuating the energy of an electromagnetic wave. The principle on which an electromagnetic shield attenuates the energy of an electromagnetic wave is not limited to a particular principle. The principle can be, for example, one using a phenomenon, such as reflection, transmission, absorption, diffraction, or interference, accompanying an interaction between an electromagnetic wave and an electromagnetic shield and a phenomenon, such as scattering or diffusion of the electromagnetic wave, caused by the above phenomenon. When a given electromagnetic wave is incident on the first surface 10 of the electromagnetic shield 1a, the energy of the electromagnetic wave is attenuated.

Since the electromagnetic shield 1a includes the plurality of first projecting portions 32 and the plurality of second projecting portions 2, the electromagnetic shield 1a is easily manufactured by molding. For example, in the case of molding using a mold composed of a movable die half and a fixed die half, easy separation of a molded article from the fixed die half as a consequence of detachment of the movable die half after molding is productive. In this case, the molded article may be obtained by pushing the molded article off the detached movable die half with a pin. It is desirable that a pin do not touch the first projecting portion 32 in manufacturing the electromagnetic shield 1a by molding because the first projecting portion 32 provided on the first surface 10 is an important structure for electromagnetic shielding. Therefore, in manufacturing the electromagnetic shield 1a by molding, it is desirable that molding be performed with the first surface 10 facing a fixed die half so that a pin for pushing a molded article in a movable die half will not touch the first projecting portion 32. Accordingly, it is desirable that molding be performed with the second surface 20 facing the movable die half. Since the electromagnetic shield 1a includes the plurality of first projecting portions 32 and the plurality of second projecting portions 2, such molding makes it easy to separate the molded article from the fixed die half as a consequence of detachment of the movable die half after molding.

In the electromagnetic shield 1a, for example, an area S2 of at least one side surface of the second projecting portions 2 is greater than an area S1 of a side surface of the first projecting portion 32, the side surface extending along a projecting direction of the first projecting portion 32. In manufacturing of the electromagnetic shield 1a by molding, such a structural feature makes it easier to separate the molded article from a fixed die half as a consequence of detachment of a movable die half after molding. The area S2 may be equal to or smaller than the area S1.

A ratio S2/S1 of the area S2 to the area S1 is not limited to a particular value. The ratio S2/S1 is, for example, 1.1 or more and 10 or less. The ratio S2/S1 may be 1.2 or more, or 1.3 or more. The ratio S2/S1 may be 7 or less, 5 or less, or 3 or less.

As shown in FIG. 1, the second projecting portion 2 projects, for example, perpendicularly from the base 5. The second projecting portion 2 may project to be inclined to the base 5.

A thickness of the base 5 is not limited to a particular value. The thickness of the base 5 is, for example, 0.5 mm to 3 mm. The thickness of the base 5 may be 0.7 mm or more, or 0.8 mm or more. The thickness of the base 5 may be 2.5 mm or less, or 2 mm or less.

As shown in FIG. 1, the first projecting portion 32 scatters, for example, the electromagnetic wave Ei incident on the electromagnetic shield 1a perpendicularly to the first surface 10 such that a radio intensity is strongest in a direction in which the electromagnetic wave Ei scattered forms a first angle $\theta1$ with a straight line perpendicular to the first surface 10. In other words, without the second projecting portion 2 in the electromagnetic shield 1a, the first projecting portion 32 would create a transmitted-scattered wave Es whose radio intensity is strongest at the first angle $\theta1$. The first angle $\theta1$ can be determined, for example, by electromagnetic field analysis simulation. The first angle $\theta1$ may be experimentally determined by allowing the electromagnetic wave Ei to be incident on a sample in the direction perpendicular to the first surface 10 of the sample, the sample being made of the electromagnetic shield 1a processed to remove the second projecting portion 2.

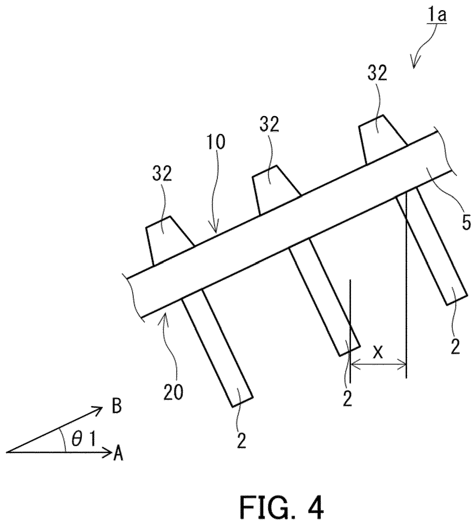

As shown in FIG. 1, the second projecting portions 2 are disposed, for example, in a particular direction at a given interval. As shown in FIG. 4, an absolute value of a distance X between a pair of the second projecting portions 2 adjacent to each other is, for example, 0 to $0.5\lambda$ or $(0.95n - 0.2)\lambda$ to $(0.95n + 0.2)\lambda$, the distance X being measured in a horizontal direction when the electromagnetic shield 1a is disposed such that the second surface 20 forms the first angle $\theta1$ with a horizontal plane. The symbol n is an integer of 1 or greater. The symbol n is, for example, 1, 2, or 3. The symbol n may be an integer of 4 or greater. The distance X is a horizontal distance, for example, between a center of a proximal end of one of a pair of the second projecting portions 2 adjacent to each other and a center of a distal end of the other second projecting portion 2. This allows the electromagnetic shield 1a to block an electromagnetic wave in a more desired state. The symbol $\lambda$ is the wavelength [mm] of the electromagnetic wave Ei. The wavelength $\lambda$ of the electromagnetic wave Ei is not limited to a particular value. The wavelength $\lambda$ of the radio wave Ei is, for example, 1 mm to 30 mm. In FIG. 4, an arrow A is horizontal, and an arrow B is parallel to the second surface 20. As shown in FIG. 4, the center of the proximal end of one of a pair of the second projecting portions 2 adjacent to each other is positioned, for example, ahead of the center of the distal end of the other second projecting portion 2 in the direction indicated by the arrow A. The center of the proximal end of one of a pair of the second projecting portions 2 adjacent to each other may be positioned behind the center of the distal end of the other second projecting portion 2 in the direction indicated by the arrow A.

The first projecting portion 32 projects, for example, from the base 5 in a direction opposite to the projecting direction of the second projecting portion 2. The first projecting portion 32 may project perpendicularly to the base 5, or may project to be inclined to the base 5.

The shape of the first projecting portion 32 and that of the second projecting portion 2 are not limited to particular shapes. At least one selected from the group consisting of the first projecting portion 32 and the second projecting portion 2 has a shape of, for example, at least one selected from the group consisting of a circle, a triangle, a quadrilateral, and a polygon having five or more corners in plan view. Such a structural feature makes it likely that the electromagnetic shield 1a exhibits desired electromagnetic shielding performance.

As shown in FIG. 1, the first projecting portion 32 has, for example, a tapered portion 32t. In the case of manufacturing of the electromagnetic shield 1a by molding with the first surface 10 facing to a fixed die half, such a structural feature makes it easy to separate the electromagnetic shield 1a being a molded article from the fixed die half as a consequence of detachment of a movable die half after molding. The first projecting portion 32 is, for example, in the shape of a truncated prism. The first projecting portion 32 may be in the shape of a truncated cone. The first projecting portion 32 may be in the shape of a prism or a cylinder.

An inclination of the tapered portion 32t is not limited to a particular value. The inclination of the tapered portion 32t is, for example, 45° or less. The inclination of the tapered portion 32t may be 40° or less, 35° or less, 30° or less, 25° or less, or 20° or less. The inclination of the tapered portion 32t may be 1° or more, 2° or more, or 3° or more.

The electromagnetic shield 1a can be used, for example, as an electromagnetic shield for millimeter-wave radars, millimeter-wave radio communication, millimeter-wave sensing, or the like. A device including the electromagnetic shield 1a can be used, for example, in automobiles and wireless base stations. When the electromagnetic shield 1a is for millimeter-wave radars, the electromagnetic shield 1a can be included in a millimeter-wave radar using one frequency band selected from the group consisting of the 24 GHz band, the 60 GHz band, the 76 GHz band, and the 79 GHz band. The electromagnetic shield 1a is not just for blocking only an electromagnetic wave with a particular wavelength, and may block electromagnetic waves in a wide wavelength region. It is also possible to regard an electromagnetic wave with a particular wavelength $\lambda$ as a "shielding target" of the electromagnetic shield 1a. For example, in the case of the electromagnetic shield installed with a vehicle-mounted millimeter-wave radar configured to irradiate an object with an electromagnetic wave practically having frequencies of 76 to 77 GHz, i.e., having practical irradiation wavelengths of 3.89 to 3.94 mm, 3.92 mm which is the wavelength of the center frequency, 76.5 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 77 to 81 GHz, i.e., using an electromagnetic wave having wavelengths of 3.70 to 3.89 mm, 3.79 mm, which is the wavelength of the center frequency, 79 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 24.05 to 24.25 GHz, i.e., using an electromagnetic wave having wavelengths of 12.36 to 12.47 mm, 12.41 mm, which is the wavelength of the center frequency, 24.15 GHz, can be understood as the wavelength $\lambda$, namely, the shielding target of this electromagnetic shield. In the case where the electromagnetic shield is for vehicle-mounted millimeter-wave radars using an electromagnetic wave having frequencies of 60.0 to 60.1 GHz, i.e., using an electromagnetic wave having wavelengths of 4.99 to 5.00 mm, 4.99 mm, which is the wavelength of the center frequency, 60.05 GHz, can be understood as the wavelength $\lambda$, namely, the shielding target of this electromagnetic shield. In the case where the electromagnetic shield is for millimeter-wave radio communication using an electromagnetic wave having frequencies of 27 to 29.5 GHz, i.e., using an electromagnetic wave having wavelengths of 10.16 to 11.10 mm, 10.61 mm, which is the wavelength of the center frequency, 28.25 GHz, can be understood as the wavelength $\lambda$, namely, the shielding target of this electromagnetic shield. In the case where the electromagnetic shield is, for example, sold with a label saying that its supporting frequencies are 70 to 90 GHz, i.e., its supporting wavelengths are 3.33 to 4.28 mm, 3.75 mm, which is the wavelength of the center frequency, 80 GHz, can be understood as the wavelength $\lambda$, namely, the shielding target of this electromagnetic shield.

A projection length $p_{1i}$ of the first projecting portion 32 is not limited to a particular value. When the particular wavelength $\lambda$, namely, the shielding target of the electromagnetic shield 1a and the projection length $p_{1i}$ are compared, the projection length $p_{1i}$ is, for example, $0.25\lambda$ or more. This allows the electromagnetic shield 1a to block an electromagnetic wave in a more desired state. The projection length $p_{1i}$ is desirably $0.51\lambda$ or more, more desirably $0.77\lambda$ or more. The projection length $p_{1i}$ is, for example, $5.1\lambda$ or less, and may be $3.5\lambda$ or less, or $3.0\lambda$ or less.

A width $w_{1i}$ of the first projecting portion 32 is not limited to a particular value. When the particular wavelength $\lambda$, namely, the shielding target of the electromagnetic shield 1a and the width $w_{1i}$ are compared, the width $w_{1i}$ is, for example, $0.12\lambda$ or more. This allows the electromagnetic shield 1a to block an electromagnetic wave in a more desired state. The width $w_{1i}$ is desirably $0.25\lambda$ or more, more desirably $0.51\lambda$ or more. The width $w_{1i}$ is, for example, $5.0\lambda$ or less, and may be $4.0\lambda$ or less, or $3.0\lambda$ or less.

An interval $i_{1i}$ between the first projecting portions 32 is a distance between the first projecting portions 32 adjacent to each other in a particular direction in plan view of the first surface 10. The interval $i_{1i}$ is not limited to a particular value. When the particular wavelength $\lambda$, namely, the shielding target of the electromagnetic shield 1a and the interval $i_{1i}$ are compared, the interval $i_{1i}$ is, for example, $5.1\lambda$ or less. This allows the electromagnetic shield 1a to block an electromagnetic wave in a more desired state. The interval $i_{1i}$ is desirably $3.10\lambda$ or less, more desirably $2.04\lambda$ or less. The interval $i_{1i}$ is, for example, $0.25\lambda$ or more, and may be $0.5\lambda$ or more, or $1.0\lambda$ or more.

The second projecting portion 2 is disposed, for example, in relation to the first projecting portion 32. This allows the electromagnetic shield 1a to block an electromagnetic wave in a more desired state. For example, a position of the second projecting portion 2 and a position of the first projecting portion 32 are in a particular relation. For example, the second projecting portions 2 and the first projecting portions 32 are aligned in a particular direction, and the first projecting portions 32 are positioned between two ends of the alignment of the second projecting portions 2 in the particular direction. Alternatively, the second projecting portions 2 and the first projecting portions 32 are aligned in a particular direction, and the second projecting portions 2 are positioned between two ends of the alignment of the first projecting portions 32 in the particular direction. The second projecting portion 2 may be disposed such that one second projecting portion 2 corresponds to one first projecting portion 32 or two or more first projecting portions 32.

For example, the second projecting portion 2 may be disposed at a position where the electromagnetic wave Ei reaches through the first projecting portion 32. Such a structural feature makes it likely that the electromagnetic shield 1a blocks an electromagnetic wave in a desired state.

As described above, the first projecting portion 32 scatters, for example, the electromagnetic wave Ei incident on the electromagnetic shield 1a in the direction perpendicular to the first surface 10 such that a radio intensity is strongest in a direction in which the electromagnetic wave Ei scattered forms the first angle $\theta1$ with a straight line LP perpendicular to the first surface 10. In this case, the second projecting portion 2 is disposed, for example, at a position where the second projecting portion 2 intersects with a straight line LS. The straight line LS is a straight line extending through an intersection JS of the perpendicular straight line LP and the second surface 20 and forming the first angle $\theta 1$ with the perpendicular straight line LP. Such a structural feature makes it likely that the electromagnetic shield 1a blocks an electromagnetic wave in a desired state.

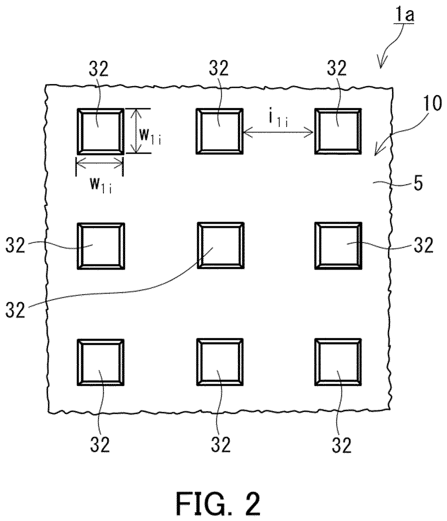

Arrangement of the plurality of first projecting portions 32 and arrangement of the plurality of second projecting portions 2 are not limited to particular arrangement. At least one selected from the group consisting of the plurality of first projecting portions 32 and the plurality of second projecting portions 2 is, for example, at least one selected from the group consisting of arrangement at lattice points, arrangement on parallel lines, and random arrangement in plan view. As shown in FIG. 2, the plurality of first projecting portions 32 may be arranged, for example, to make a square lattice, a rectangular lattice, or a parallelogram lattice when the first surface 10 is viewed in plan. In this case, an electromagnetic wave can be blocked in a more desired state. The first projecting portion 32 may be a projecting strip. In this case, the first projecting portion 32 may include a plurality of projecting strips disposed parallel to each other. In this case, each projecting strip may extend linearly, in a wavelike manner, or in a zig-zag manner.

The electromagnetic shield 1a may include a plurality of holes disposed apart from each other in plan view of the first surface 10. In this case, a structure 30 including the plurality of holes can function as a diffraction grating. A depth of the hole is not limited to a particular value. When the particular wavelength $\lambda$, namely, the shielding target of the electromagnetic shield 1a and the depth of the hole are compared, the depth of the hole is, for example, $0.25\lambda$ or more. This allows the electromagnetic shield 1a to block an electromagnetic wave in a more desired state. The depth of the hole is desirably $0.51\lambda$ or more, more desirably $0.77\lambda$ or more. The depth of the hole is, for example, $5.1\lambda$ or less, and may be $3.5\lambda$ or less, or $3.0\lambda$ or less.

In the case where the electromagnetic shield 1a includes the plurality of holes disposed apart from each other in plan view of the first surface 10, a distance between the holes adjacent to each other in a particular direction in plan view of the first surface 10 is not limited to a particular value. When the particular wavelength $\lambda$, namely, the shielding target of the electromagnetic shield 1a and the distance between the holes are compared, the distance between the holes is, for example, $0.12\lambda$ or more. This allows the electromagnetic shield 1a to block an electromagnetic wave in a more desired state. The distance between the holes is desirably $0.25\lambda$ or more, more desirably $0.51\lambda$ or more. The distance between the holes is, for example, $5.0\lambda$ or less, and may be $4.0\lambda$ or less, or $3.0\lambda$ or less.

In the case where the electromagnetic shield 1a includes the plurality of holes disposed apart from each other in plan view of the first surface 10, a width of the hole is not limited to a particular value. When the particular wavelength $\lambda$, namely, the shielding target of the electromagnetic shield 1a and the width of the hole are compared, the width of the hole is, for example, $5.1\lambda$ or less. This allows the electromagnetic shield 1a to block an electromagnetic wave in a more desired state. The width of the hole is desirably $3.10\lambda$ or less, more desirably $2.04\lambda$ or less. The width of the hole is, for example, $0.25\lambda$ or more, and may be $0.5\lambda$ or more, or $1.0\lambda$ or more.

As described above, the shape of the second projecting portion 2 is not limited to a particular one. The second projecting portion 2 has a shape, for example, selected from the group consisting of a plate, a pillar, a cone, a pyramid, and a projecting strip. In this case, the electromagnetic shield 1a can block an electromagnetic wave in a desired state. In the example shown in FIGS. 1 and 2, the second projecting portion 2 has the shape of a plate. The second projecting portion 2 may have the shape of a truncated cone or a truncated pyramid. When the second projecting portion 2 is a projecting strip, the shape of a cross-section of the projecting strip in a direction perpendicular to a longitudinal direction of the projecting strip may be a rectangle, a triangle, a semicircle, or a semi ellipse. The second projecting portion 2 may include a plurality of projecting strips disposed parallel to each other. In this case, each projecting strip may extend linearly, in a wavelike manner, or in a zig-zag manner.

As shown in FIG. 1, a width $w_{2i}$ of the second projecting portion 2 is not limited to a particular value. The width $w_{2i}$ is the smallest dimension of the second projecting portion 2 in a direction perpendicular to the projecting direction of the second projecting portion 2. The width $w_{2i}$ is, for example, smaller than the width $w_{1i}$ of the first projecting portion 32. The width $w_{1i}$ is a dimension of the first projecting portion 32 in the direction where the width $w_{2i}$ is defined. When the width $w_{2i}$ is smaller than the width $w_{1i}$, the amount of a material used for the electromagnetic shield 1a is likely to decrease. A ratio of the width $w_{2i}$ to the width $w_{1i}$ is, for example, 0.1 to 0.8, and may be 0.2 to 0.5. The width $w_{2i}$ may be greater than the width $w_{1i}$.

When the particular wavelength $\lambda$, namely, the shielding target of the electromagnetic shield 1a and the width $w_{2i}$ are compared, the width $w_{2i}$ of the second projecting portion 2 is, for example, $0.12\lambda$ to $0.65\lambda$. In this case, the electromagnetic shield 1a can block an electromagnetic wave in a more desired state. The width $w_{2i}$ may be $0.7\lambda$ or more, or $0.8\lambda$ or more. The width $w_2$ may be $0.1\lambda$ or less, or $0.08\lambda$ or less.

A projection length $p_{2i}$ of the second projecting portion 2 is not limited to a particular value. The projection length $p_{2i}$ is, for example, longer than the projection length $p_{1i}$ of the first projecting portion 32. In this case, it is easy to adjust the ratio S2/S1 to a desired value. A ratio $p_{2i}/p_{1i}$ of the projection length $p_{2i}$ to the projection length $p_{1i}$ is, for example, 1.1 to 5. The ratio $p_{2i}/p_{1i}$ may be 1.2 or more, 1.3 or more, or 1.5 or more. The ratio $p_{2i}/p_{1i}$ may be 4 or less, or 3 or less.

When the particular wavelength $\lambda$, namely, the shielding target of the electromagnetic shield 1a and the projection length $p_{2i}$ are compared, the projection length $p_{2i}$ of the second projecting portion 2 is, for example, $0.5\lambda$ to $3.0\lambda$. In this case, the electromagnetic shield 1a can block an electromagnetic wave in a more desired state. The projection length $p_{2i}$ may be $3.5\lambda$ or more, or $4.0\lambda$ or more. The projection length $p_{2i}$ may be $0.4\lambda$ or less, or $0.3\lambda$ or less.

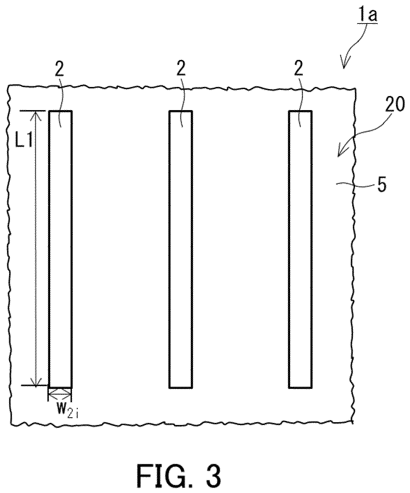

As shown in FIGS. 1 and 3, the second projecting portion 2 includes the plurality of second projecting portions 2. An interval $i_{2i}$ between the second projecting portions 2 is a distance between the second projecting portions 2 adjacent to each other in a particular direction when the second projecting portion 2 is viewed in plan along the direction opposite to the projecting direction of the second projecting portion 2. The interval $i_{2i}$ is not limited to a particular value. For example, when the second projecting portion 2 has the shape of a plate, the particular direction is a thickness direction of the second projecting portion 2. The interval $i_{2i}$ is, for example, greater than the interval $i_{1i}$ between the first projecting portions 32 adjacent to each other in the particular direction in plan view of the first surface 10. In this case, the amount of a material used for the electromagnetic shield 1a is likely to decrease.

When the particular wavelength $\lambda$, namely, the shielding target of the electromagnetic shield 1a and the interval $i_{2i}$ are compared, the interval $i_{2i}$ is, for example, $1.0\lambda$ to $3.8\lambda$. In this case, the electromagnetic shield 1a can block an electromagnetic wave in a more desired state. The interval $i_{2i}$ may be $4.0\lambda$ or more, or $5.0\lambda$ or more. The interval $i_{2i}$ may be $0.8\lambda$ or less, or $0.5\lambda$ or less.

For example, at least one selected from the group consisting of at least one of the projection lengths $p_{1i}$ of the first projecting portions 32 and at least one of the projection lengths $p_{2i}$ of the second projecting portions satisfies at least one selected from the group consisting of a requirement $0.25\lambda \leq p_{1i} \leq 1.3\lambda$ and a requirement $0.25\lambda \leq p_{2i} \leq 1.3\lambda$. Such a structural feature makes it likely that the electromagnetic shield 1a blocks an electromagnetic wave in a desired state.

When the requirement $0.25\lambda \leq p_{1i} \leq 1.3\lambda$ or $0.25\lambda \leq p_{2i} \leq 1.3\lambda$ is satisfied, the projection length $p_{1i}$ or $p_{2i}$ may be $0.30\lambda$ or more, $0.35\lambda$ or more, $0.40\lambda$ or more, $0.45\lambda$ or more, or $0.50\lambda$ or more. The projection length $p_{1i}$ or $p_{2i}$ may be $1.2\lambda$ or less, $1.1\lambda$ or less, $1.0\lambda$ or less, or $0.9\lambda$ or less.

Fifty percent or more of the first projecting portions 32 on a number basis satisfy, for example, the requirement $0.25\lambda \leq p_{1i} \leq 1.3\lambda$. Sixty percent or more of the first projecting portions 32 on a number basis may satisfy the requirement $0.25\lambda \leq p_{1i} \leq 1.3\lambda$. Seventy percent or more of the first projecting portions 32 on a number basis may satisfy the requirement $0.25\lambda \leq p_{1i} \leq 1.3\lambda$. Eighty percent or more of the first projecting portions 32 on a number basis may satisfy the requirement $0.25\lambda \leq p_{1i} \leq 1.3\lambda$. Ninety percent or more of the first projecting portions 32 on a number basis may satisfy the requirement $0.25\lambda \leq p_{1i} \leq 1.3\lambda$. All first projecting portions 32 may satisfy the requirement $0.25\lambda \leq P \leq 1.3\lambda$.

Fifty percent or more of the second projecting portions 2 on a number basis satisfy, for example, the requirement $0.25\lambda \leq p_{2i} \leq 1.3\lambda$. Sixty percent or more of the second projecting portions 2 on a number basis may satisfy the requirement $0.25\lambda \leq p_{2i} \leq 1.3\lambda$. Seventy percent or more of the second projecting portions 2 on a number basis may satisfy the requirement $0.25\lambda \leq p_{2i} \leq 1.3\lambda$. Eighty percent or more of the second projecting portions 2 on a number basis may satisfy the requirement $0.25\lambda \leq p_{2i} \leq 1.3\lambda$. Ninety percent or more of the second projecting portions 2 on a number basis may satisfy the requirement $0.25\lambda \leq p_{2i} \leq 1.3\lambda$. All second projecting portions 2 may satisfy the requirement $0.25\lambda \leq p_{2i} \leq 1.3\lambda$.

For example, at least one selected from the group consisting of at least one of the widths $w_{1i}$ of the first projecting portions 32 and at least one of the widths $w_{2i}$ of the second projecting portions 2 satisfies at least one selected from the group consisting of a requirement $0.51\lambda \leq w_{1i} \leq 1.6\lambda$ and a requirement $0.51\lambda \leq w_{2i} \leq 1.6\lambda$. Such a structural feature makes it likely that the electromagnetic shield 1a blocks an electromagnetic wave in a desired state.

When the requirement $0.51\lambda \leq w_{1i} \leq 1.6\lambda$ or $0.51\lambda \leq w_{2i} \leq 1.6\lambda$ is satisfied, the width $w_{1i}$ or $w_{2i}$ may be $0.55\lambda$ or more, $0.60\lambda$ or more, $0.65\lambda$ or more, $0.70\lambda$ or more, or $0.75\lambda$ or more. The width $w_{1i}$ or $w_{2i}$ may be $1.5\lambda$ or less, $1.4\lambda$ or less, $1.3\lambda$ or less, $1.2\lambda$ or less, $1.1\lambda$ or less, or $1.0\lambda$ or less.

Fifty percent or more of the first projecting portions 32 on a number basis satisfy, for example, the requirement $0.51\lambda \leq w_{1i} \leq 1.6\lambda$. Sixty percent or more of the first projecting portions 32 on a number basis may satisfy the requirement $0.51\lambda \leq w_{1i} \leq 1.6\lambda$. Seventy percent or more of the first projecting portions 32 on a number basis may satisfy the requirement $0.51\lambda \leq w_{1i} \leq 1.6\lambda$. Eighty percent or more of the first projecting portions 32 on a number basis may satisfy the requirement $0.51\lambda \leq w_{1i} \leq 1.6\lambda$. Ninety percent or more of the first projecting portions 32 on a number basis may satisfy the requirement $0.51\lambda \leq w_{1i} \leq 1.6\lambda$. All first projecting portions 32 may satisfy the requirement $0.51\lambda \leq w_{1i} \leq 1.6\lambda$.

Fifty percent or more of the second projecting portions 2 on a number basis satisfy, for example, the requirement $0.51\lambda \leq w_{2i} \leq 1.6\lambda$. Sixty percent or more of the second projecting portions 2 on a number basis may satisfy the requirement $0.51\lambda \leq w_{2i} \leq 1.6\lambda$. Seventy percent or more of the second projecting portions 2 on a number basis may satisfy the requirement $0.51\lambda \leq w_{2i} \leq 1.6\lambda$. Eighty percent or more of the second projecting portions 2 on a number basis may satisfy the requirement $0.51\lambda \leq w_{2i} \leq 1.6\lambda$. Ninety percent or more of the second projecting portions 2 on a number basis may satisfy the requirement $0.51\lambda \leq w_{2i} \leq 1.6\lambda$. All second projecting portions 2 may satisfy the requirement $0.51\lambda \leq w_{2i} \leq 1.6\lambda$.

For example, at least one selected from the group consisting of the interval $i_{1i}$ between the first projecting portions 32 and the interval $i_{2i}$ between the second projecting portions 2 satisfies at least one selected from the group consisting of a requirement $0.51\lambda \leq i_{1i} \leq 1.6\lambda$ and a requirement $0.51\lambda \leq i_{2i} \leq 1.6\lambda$. Such a structural feature makes it likely that the electromagnetic shield 1a blocks an electromagnetic wave in a desired state. When the requirement $0.51\lambda \leq in \leq 1.6\lambda$ or $0.51\lambda \leq i_{2i} \leq 1.6\lambda$ is satisfied, the interval $i_{1i}$ or the interval $i_{2i}$ may be $0.55\lambda$ or more, $0.60\lambda$ or more, $0.65\lambda$ or more, $0.70\lambda$ or more, or $0.75\lambda$ or more. The interval $i_{1i}$ or the interval $i_{2i}$ may be $1.5\lambda$ or less, $1.4\lambda$ or less, or $1.3\lambda$ or less.

As shown in FIG. 3, the second projecting portion 2 is long and extends, for example, in a given direction when the second surface 20 is viewed in plan. A dimension L1 of the second projecting portion 2 in a longitudinal direction thereof in plan view of the second surface 20 is not limited to a particular value. When the particular wavelength $\lambda$, namely, the shielding target of the electromagnetic shield 1a and the dimension L1 are compared, the dimension L1 is, for example, $1.2\lambda$ to $25\lambda$. The dimension L1 may be, for example, $1.5\lambda$ or more, or $2.0\lambda$ or more. The dimension L1 may be $20\lambda$ or less, or $15\lambda$ or less.

The electromagnetic shield 1a satisfies, for example, at least one of the following requirements (I) and (II). Such a structural feature makes it likely that the electromagnetic shield 1a blocks an electromagnetic wave in a desired state. In the requirements (I) and (II), $S_{p1}$ is an area of the plurality of first projecting portions 32 measured when the first surface 10 is viewed in plan, $S_{p2}$ is an area of the plurality of second projecting portions 32 measured when the second surface 20 is viewed in plan. Additionally, $S_e$ is an area of the entire electromagnetic shield 1a measured when the first surface 10 is viewed in plan, and $S_o$ is an area of the entire electromagnetic shield 1a measured when the second surface 20 is viewed in plan.

$$0.2 \leq S_{p1}/S_e \leq 0.8 \qquad (I)$$

$$0.2 \leq S_{p2}/S_o \leq 0.8 \qquad (II)$$

As described above, the electromagnetic shield 1a includes a dielectric. A relative permittivity of the dielectric is not limited to a particular value. An imaginary part $\varepsilon''$ of the relative permittivity of the dielectric at at least one frequency $f_g$ in a range of 10 GHz to 300 GHz is, for example, 0.1 or less. It appears that the imaginary part $\varepsilon''$ of the dielectric is desirably large in the case of attenuating an electromagnetic wave using a dielectric loss. However, even if the imaginary part $\varepsilon''$ of the relative permittivity of the dielectric is as small as 0.1 or less, the electromagnetic shield 1a is likely to exhibit desired performance by adjusting a phenomenon caused by an interaction between the electromagnetic shield 1a and an electromagnetic wave. The imaginary part $\varepsilon''$ may be 0.07 or less, 0.05 or less, or 0.01 or less.

A real part $\varepsilon'$ of the relative permittivity of the dielectric included in the electromagnetic shield 1a is not limited to a particular value. For example, the real part $\varepsilon'$ of the relative permittivity of the dielectric at at least one frequency $f_g$ in a range of 10 GHz to 300 GHz is 2.0 to 4.0. Even in this case, the electromagnetic shield 1a is likely to exhibit desired performance by adjusting a phenomenon caused by an interaction between the electromagnetic shield 1a and an electromagnetic wave. The real part $\varepsilon'$ may be 3.8 or less, 3.6 or less, 3.4 or less, 3.2 or less, 3.0 or less, 2.8 or less, 2.6 or less, or 2.4 or less. The real part $\varepsilon'$ is desirably 2.1 or more and 3.5 or less, more desirably 2.2 or more and 3.0 or less.

The electromagnetic shield 1a is, for example, free of an electrically conductive portion. For electromagnetic shielding, for example, an electrically conductive portion such as a metal film may be used to reflect an electromagnetic wave. However, the electromagnetic shield 1a can block an electromagnetic wave without an electrically conductive portion. The electromagnetic shield 1a may consist of the dielectric. The electromagnetic shield 1a may include an electrically conductive portion.

The electromagnetic shield 1a is, for example, a resin molded article. In this case, the cost of manufacturing the electromagnetic shield 1a is likely to be low. The resin included in the resin molded article is not limited to a particular resin.

The resin is, for example, a thermoplastic resin. Examples of the resin include polyethylene, polypropylene, polyvinyl alcohol, polyethylene terephthalate, polybutylene terephthalate, ethylene-vinyl acetate copolymer, polystyrene, acrylonitrile styrene, acrylonitrile-butadiene-styrene copolymer, ASA resin, AES resin, acrylic resins such as PMMA, MS resin, MBS resin, cycloolefin resin, polyacetal resin, polyamide resin, polyester resin, polycarbonate resin, polyurethane resin, liquid crystal polymer, EPDM, PPS, PEEK, PPE, polysulfone-based resin, polyimide-based resin, fluorine resin, thermoplastic elastomers such as an olefin-based thermoplastic elastomer (TPO), and acrylic elastomers. The resin may be a thermosetting resin. The thermosetting resin is, for example, an epoxy resin, an acrylic resin, or a silicone resin. The resin molded article may include only one resin or two or more resins.

The electromagnetic shield 1a may include, for example, a filler. The filler may be a colorant such as carbon black, an inorganic reinforcement such as talc, glass fibers, or a mineral, or a softener. The electromagnetic shield 1a may include an additive such as a flame retardant or a plasticizer. The electromagnetic shield 1a may be free of a filler. In this case, the cost of manufacturing the electromagnetic shield 1a is likely to be low.

In the case where the electromagnetic shield 1a is a resin molded article, the method for molding the electromagnetic shield 1a is not limited to a particular method. The electromagnetic shield 1a can be manufactured by injection molding, press molding, blow molding, or vacuum molding.

For the electromagnetic shield 1a, an interaction occurring between the electromagnetic shield and an electromagnetic wave for blocking of the electromagnetic wave is not limited to a particular interaction. The electromagnetic shield 1a, for example, transmits at least a portion of an electromagnetic wave incident on the first surface 10 and allows a scattered electromagnetic wave to emerge from the second surface 20. In other words, the electromagnetic shield 1a can function as a radio-wave transmitting-scattering body. Electromagnetic shielding can therefore be achieved with a simple configuration.

The electromagnetic shield 1a has a scattering ratio of, for example, 0.1% or more. The term "scattering ratio" refers to a ratio of an intensity of a particular transmitted-scattered wave to an intensity of a straight transmitted wave emerging from the second surface 20, the intensities being measured when the radio wave Ei is perpendicularly incident on the first surface 10. The scattering ratio is determined, for example, by the following equation (1). In the equation (1), "Intensity of transmitted-scattered wave" is, for example, a sum of intensities measured for a transmitted-scattered wave at scattering angles of 15°, 30°, 45°, 60°, and 75°. The term "scattering angle" refers to an angle between an emergent direction of a straight transmitted wave and an emergent direction of a transmitted-scattered wave.

$$\text{Scattering ratio} = \text{Intensity of transmitted-scattered wave/Intensity of straight transmitted wave} \qquad \text{Equation (1)}$$

The intensity of the transmitted-scattered wave and the intensity of the straight transmitted wave can be determined with reference to Japanese Industrial Standards (JIS) R 1679: 2007, for example, by allowing the radio wave Ei to be perpendicularly incident on the first surface 10 and measuring a transmission loss in a straight direction and a transmission loss at a given scattering angle. Each transmission loss is expressed by the following equation (2). In the equation (2), $P_i$ is a received electric power, and $P_0$ is a transmitted electric power. $|P_i/P_0|$ corresponds to the intensity of a transmitted wave. "Log" represents a common logarithm.

$$\text{Transmission loss} = |10\text{Log}(P_i/P_0)| \qquad (2)$$

The scattering ratio of the electromagnetic shield 1a may be 1 % or more, 5% or more, 10% or more, 20% or more, 50% or more, 100% or more, 150% or more, or 200% or more.

The structure 30 including the plurality of first projecting portions 32 is thought to function, for example, as a diffraction grating in the electromagnetic shield 1a. Regarding light diffraction, a zero-order light transmittance $I_0$ through a diffraction grating having a rectangular cross-section is expressed by the following equation (3) in accordance with a scalar diffraction theory. In the equation (3), $\varepsilon_r$ is the real part of the relative permittivity of the material forming the diffraction grating, and sqrt($\varepsilon_r$) is a square root of $\varepsilon_r$. The symbol h is a height of a protruding portion of the diffraction grating. The symbol $\lambda$ is the wavelength of light.

$$I_0 = \cos^2(\pi \cdot |\text{sqrt}(\varepsilon_r)| - 1 \cdot (h/\lambda)) \qquad \text{Equation (3)}$$

According to Bragg's law, a direction (scattering angle) of a scattered-transmitted wave generated by diffraction is determined by a pitch of protruding portions of a diffraction grating. Constructive interference and destructive interference between diffraction waves having passed through between the protruding portions generate an interference fringe. It is thought that in this case, a transmitted-scattered wave is observed as a result of constructive interference between diffraction waves. Constructive interference between diffraction waves can be expressed by an equation (4), while destructive interference between diffraction waves can be expressed by an equation (5). In the equations (4) and (5), d is a pitch of protruding portions of a diffraction grating, $\theta$ is an angle at which constructive interference or destructive interference between diffraction waves occurs, m is an integer of 0 or greater, and $\lambda$ is the wavelength of an incident wave. It is understood that when $\lambda$ is constant, the scattering angle of a transmitted-scattered wave can vary depending on the pitch of the protruding portions of the diffraction grating. Table 1 shows an example of a relation between the scattering angle $\theta$ at which constructive interference between diffraction waves occurs and the pitch d.

$$d\sin\theta = m\lambda \qquad \text{Equation (4)}$$

$$dsin\theta = (m + 1/2)\lambda \qquad \text{Equation (5)}$$

[Table 1]

| Scattering angle θ | | | Interference | Pitch d [mm] of protruding portions of diffraction grating | | | | | | | | |
|---|---|---|---|---|---|---|---|---|---|---|---|---|
| | | | | 4 | 5 | 6 | 7 | 8 | 9 | 10 | 11 | 12 |
| Order of diffraction m | | 0 | Constructive | 0° | 0° | 0° | 0° | 0° | 0° | 0° | 0° | 0° |
| | | 0 | Destructive | 29° | 23° | 19° | 16° | 14° | 13° | 11° | 10° | 9° |
| | | 1 | Constructive | 79° | 52° | 41° | 34° | 29° | 26° | 23° | 21° | 19° |
| | | 1 | Destructive | - | - | 79° | 57° | 47° | 41° | 36° | 32° | 29° |
| | | 2 | Constructive | - | - | - | - | 79° | 61° | 52° | 45° | 41° |
| | | 2 | Destructive | - | - | - | - | - | - | 79° | 63° | 55° |
| | | 3 | Constructive | - | - | - | - | - | - | - | - | 79° |

As shown in FIGS. 1 and 2, the structure 30 includes, for example, the plurality of first projecting portions 32. In this case, for example, it is understood from the above equation (3) that transmission and scattering of the radio wave Ei can be achieved in a desired state by adjusting the projection length of the first projecting portion 32.

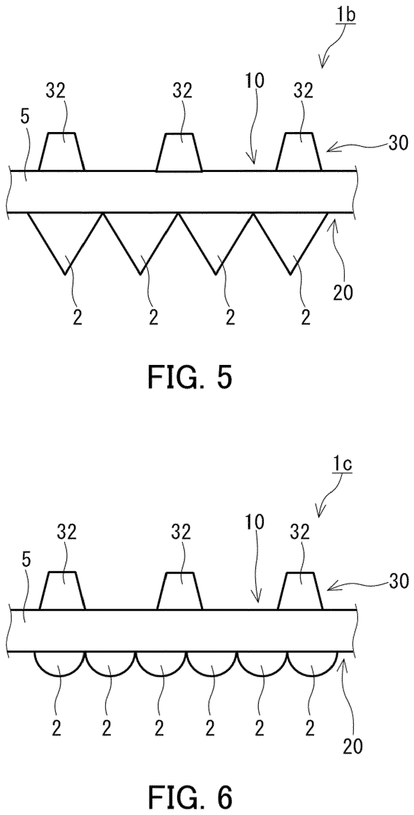

The electromagnetic shield 1a may be modified to an electromagnetic shield 1b and an electromagnetic shield 1c as shown in FIG. 5 and FIG. 6, respectively. Each of the electromagnetic shield 1b and the electromagnetic shield 1c is configured in the same manner as the electromagnetic shield 1a unless otherwise described. The components of the electromagnetic shield 1b and the electromagnetic shield 1c that are the same as or correspond to the components of the electromagnetic shield 1a are denoted by the same reference characters and detailed descriptions of such components are omitted. The description given for the electromagnetic shield 1a applies to the electromagnetic shield 1b and the electromagnetic shield 1c, unless there is technical inconsistency.

As shown in FIG. 5, the second projecting portion 2 of the electromagnetic shield 1b is a projecting strip, and a cross-section of the projecting strip in the direction perpendicular to the longitudinal direction of the projecting strip is isosceles triangular. The second projecting portion 2 includes a plurality of projecting strips disposed parallel to each other, and the projecting strips are provided such that bottom portions of the projecting strips adjacent to each other are in contact with each other. Such a structural feature also can make it possible to block an electromagnetic wave incident on the first surface 10 and makes it easy to manufacture the electromagnetic shield 1b by molding.

As shown in FIG. 6, the second projecting portion 2 of the electromagnetic shield 1c is a projecting strip, and a cross-section of the projecting strip in the direction perpendicular to the longitudinal direction of the projecting strip is semicircular. The second projecting portion 2 includes projecting strips disposed parallel to each other, and the projecting strips are provided such that the bottom portions of the projecting strips adjacent to each other are in contact with each other. Such a structural feature also can make it possible to block an electromagnetic wave incident on the first surface 10 and makes it easy to manufacture the electromagnetic shield 1c by molding.

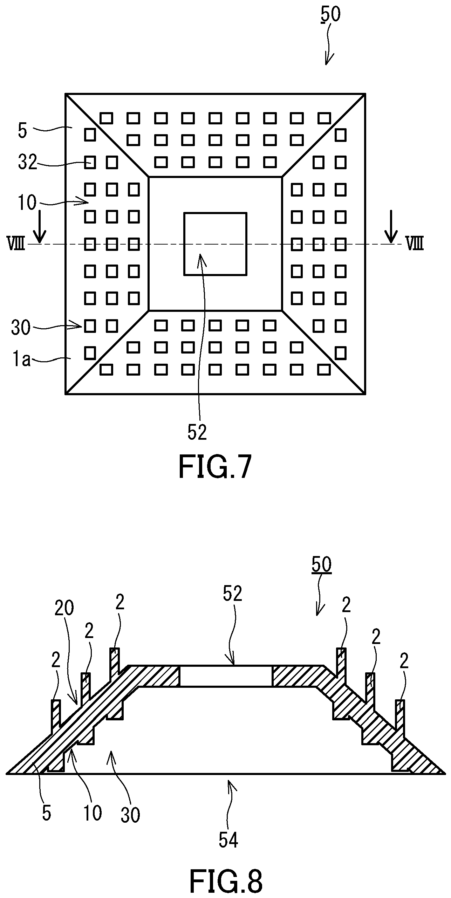

The shapes of the electromagnetic shield 1a and the base 5 are not limited to particular ones. As shown in FIGS. 7 and 8, at least one of the electromagnetic shield 1a and the base 5 may be a ring-shaped body and may have a polygonal or circular outer perimeter when the first surface 10 is viewed along an axis of the ring-shaped body. With such a structural feature, an electromagnetic wave incident on the first surface 10 through a space surrounded by at least one of the electromagnetic shield 1a and the base 5 can be blocked.

As shown in FIGS. 7 and 8, an outer shape of at least one of the electromagnetic shield 1a and the base 5 is, for example, a truncated pyramidal shape. At least one of the electromagnetic shield 1a and the base 5 is, for example, a hollow body and has an opening in each of positions in the outer shape, the positions corresponding to an upper base and a lower base of a truncated pyramid. At least one of the electromagnetic shield 1a and the base 5 has, for example, a first opening 52 in a position corresponding to the upper base of a truncated pyramid and a second opening 54 in a position corresponding to the lower base thereof. The first surface 10 defines an inner peripheral surface of the hollow body being the electromagnetic shield 1a or the base 5. The second surface 20 defines an outer peripheral surface of the hollow body being the electromagnetic shield 1a or the base 5. Such a structural feature makes it likely that electromagnetic shielding by the electromagnetic shield 1a is achieved in a larger space. Furthermore, the first opening 52 of the electromagnetic shield 1a can be used to dispose therein an antenna for transmission and reception of an electromagnetic wave. The outer shape of at least one of the electromagnetic shield 1a and the base 5 may be a truncated conical shape or a truncated elliptical conical shape. In this case, the electromagnetic shield 1a has an opening in each of positions in the outer shape, the positions corresponding to the upper base and the lower base of a truncated cone or a truncated elliptic cone.

The first projecting portions 32 project, for example, in a direction perpendicular to the lower base of a truncated polygonal pyramid, a truncated cone, or a truncated elliptic cone being the outer shape of the electromagnetic shield 1a or the base 5. Such a structural feature makes it likely that the electromagnetic shield 1a has higher electromagnetic shielding performance. Such a structural feature also makes it easy to manufacture the electromagnetic shield 1a by molding.

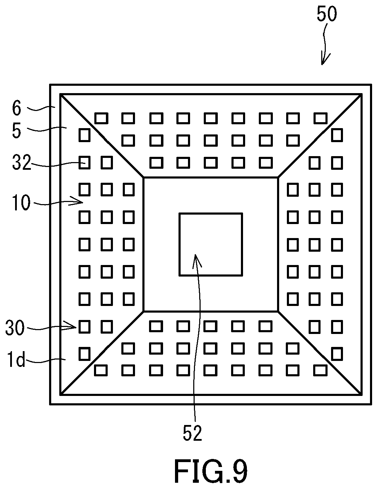

The electromagnetic shield 1a may be modified to an electromagnetic shield 1d as shown in FIG. 9. The electromagnetic shield 1d is configured in the same manner as the electromagnetic shield 1a unless otherwise described. The electromagnetic shield 1d includes a contact portion 6. The contact portion 6 is a portion configured to be in contact with a component other than the electromagnetic shield 1b. The contact portion 6 abuts on a polygonal or circular outer perimeter seen when the first surface 10 is viewed along the axis of the electromagnetic shield 1d or the base 5 in a ring shape. With such a configuration, the electromagnetic shield 1b can be attached to another component with the contact portion 6 in contact with the other component. The contact portion 6 forms, for example, a flange.

As shown in FIGS. 7 and 8, for example, a radar cover 50 including the electromagnetic shield 1a can be provided.

The radar cover 50 is, for example, in the shape of a hollow truncated pyramid, and has the first opening 52 and the second opening 54. The first opening 52 and the second opening 54 are each rectangular. The second opening 54 is bigger than the first opening 52. A portion, such as an antenna of a radar (not illustrated), of a radar is disposed in the first opening 52. An internal surface of the radar cover 50 is formed of the first surface 10 of the electromagnetic shield 1a, and the first projecting portions 32 are provided on the internal surface. On the other hand, an external surface of the radar cover 50 is formed of the second surface 20 of the electromagnetic shield 1a, and the second projecting portions 2 are provided on the outer surface.

Unnecessary radio waves incident on the internal surface of the radar cover 50 is blocked by the electromagnetic shield 1a. This can consequently prevent a radar from receiving unnecessary radio waves.

EXAMPLES

The present invention will be described hereinafter in more details by examples. The present invention is not limited to the examples given below. First, evaluation methods for Examples and Comparative Examples will be described.

[Transmission loss]

A radio wave having a frequency of 76.5 GHz (wavelength $\lambda$: 3.919 mm) was allowed to be incident on each of samples according to Examples and Comparative Examples in a direction perpendicular to a first surface thereof to measure a transmission loss in the straight direction using a radio transceiver EAS02 manufactured by KEYCOM Corporation with reference to JIS R 1679: 2007. In this measurement, the measurement region had a diameter of 30 mm. The transmission loss was determined by the above equation (2). Table 2 shows the results.

[Electromagnetic field analysis simulation]

By electromagnetic field analysis simulation was determined a direction in which a radio wave incident perpendicularly to the first surface of each of the samples according to Examples 1, 4, 8, and 9 is transmitted and scattered by a structure of the first surface side of each sample and in which a radio intensity of the radio wave transmitted and scattered is strongest. Table 2 shows the angle $\theta 1$ formed between the direction and a straight line perpendicular to the first surface. Incidentally, computation models in which the samples did not have ribs were used in this electromagnetic field analysis simulation. The angles $\theta 1$ of the samples according to Examples 2, 3, 6, 7, and 10 and Comparative Example 1 were considered identical to the angle $\theta 1$ of the sample according to Example 1. The angles $\theta 1$ of the samples according to Examples 5, 11, and 12 and Comparative Example 2 were considered identical to the angle $\theta 1$ of the sample according to Example 4. The angles $\theta 1$ of the samples according to Comparative Examples 3 and 4 were considered identical to the angles $\theta 1$ of the samples according to Examples 8 and 9, respectively.

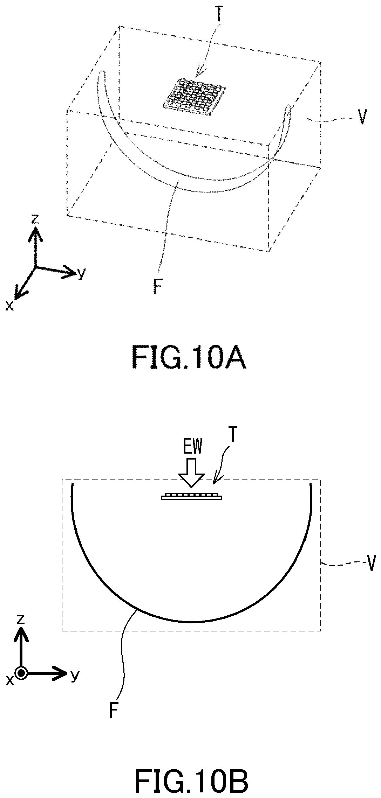

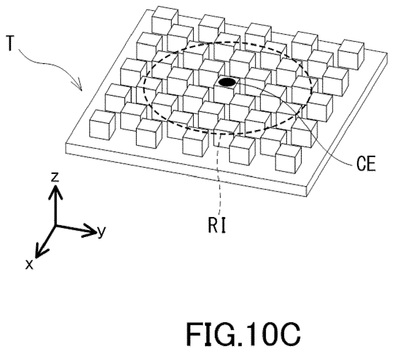

FIG. 10A to FIG. 10C schematically show a computation model used to determine the angle $\theta 1$ for the structure of the first surface side of the sample according to Example 1. In this computation model, a target T simulating the structure of the first surface side of the sample according to Example 1 was disposed at a given position in a rectangular parallelepiped calculation region V. As shown in FIG. 10B, an electromagnetic wave EM at 76.5 GHz was incident perpendicularly to the first surface side of the target T, and an electromagnetic field intensity in the calculation region V was calculated. The real part $\varepsilon'$ of the relative permittivity of target T was 2.43, and the imaginary part $\varepsilon''$ of the relative permittivity was 0.005. The target T was in the shape of a square 60 mm on a side in plan view, a thickness of a portion of the target T was 2.5 mm, the portion corresponding to a flat-plate-shaped base. A region RI indicated by a dashed line in FIG. 10C is a region irradiated with the electromagnetic wave EM and is a 30 mm-diameter circle having its center at a center CE. The center CE corresponds to the center of the electromagnetic wave EM. An amplitude direction of the electric field of the electromagnetic wave EM is parallel to the y-axis direction, is parallel to one pair of opposite sides of an outline of the target T having a square shape in plan view, and is perpendicular to the other pair of opposite sides. As shown in FIG. 10A and FIG. 10B, a receiving plane F was defined in the calculation region V. The receiving plane F is 120 mm away from an intersection of a straight line and a second surface of the target T, the straight line being perpendicular to the first surface of the target T and passing through the center CE. The receiving plane F was formed of a series of one hundred and eighty-one 30 mm-diameter circles having, as their centers, one hundred and eighty-one points 1° distant from each other. The one hundred and eighty-one points were present in a plane parallel to the z-y plane. One of the one hundred and eighty-one points was on the straight line being perpendicular to the first surface of the target T and passing through the center CE. An angle formed between a line segment and the straight line being perpendicular to the first surface of the target T and passing through the center CE was -90° or 90°, the line segment connecting two points positioned at two ends of the one hundred and eighty-one points and the intersection of the straight line and the second surface of the target T.

Calculation using this computation model was performed using a software, Electronics Desktop HFSS 2021 R1, manufactured by ANSYS, Inc. This calculation was performed by the finite element method (FEM). In the FEM, the number of meshes of the calculation region V was 500000, and the number of meshes of the target T was 70000.

In the above computation model, the electromagnetic wave EM was allowed to be incident on the target T, and electric powers at the above one hundred and eighty-one points forming the receiving plane F were determined. The largest electric power of these electric powers was defined as a maximum transmitted power $T_{max}$ [W]. An angle formed between a line segment and the straight line being perpendicular to the first surface of the target T and passing through the center CE was determined as θ1, the line segment connecting a point of the maximum transmitted power $T_{max}$ and the intersection of the straight line and the second surface of the target T. The angle θ1 of each of the samples according to Examples 4, 8, and 9 was determined in the same manner as the above calculation, except that the target T was produced to simulate the structure of the first surface side of each of the samples according to Examples 4, 8, and 9.

<Example 1>

A resin molded article having a plurality of truncated square pyramidal projections on one principal surface and four plate-shaped ribs on the other principal surface was produced by molding using an olefin-based thermoplastic elastomer. The sample according to Example 1 was obtained in this manner. The real part ε' of a complex relative permittivity of the olefin-based thermoplastic elastomer at a frequency of 76.5 GHz was 2.43, and the imaginary part ε" thereof was 0.005. In the sample according to Example 1, the principal surface having the plurality of truncated square pyramidal projections is the first surface, and the principal surface having the four plate-shaped ribs is the second surface. In the sample according to Example 1, the above projections and the above ribs projected in opposite directions from a 2 mm-thick flat-plate-shaped base. Each projection had a height (projection length) of 5 mm and a width of 5 mm. An inclination of the tapered portion of each projection was 3°. The plurality of projections were arranged to make a parallelogram lattice in plan view of the first surface. A distance between the projections adjacent to each other was 6.5 mm. A sum of the areas of side surfaces of the plurality of projections was 27 cm², the side surfaces extending along a projecting direction of the plurality of projections.

When the second surface was viewed in plan, the four ribs were aligned at an interval of 12.5 mm along an alignment direction of the projections. Each rib had a height (projection length) of 10 mm and a width of 2 mm. The width of the rib is a dimension of the rib in the above alignment direction. A length of the rib is a dimension of the rib in a direction perpendicular to the above alignment direction and parallel to the second surface. Each rib had a length of about 5 cm. A sum of the areas of side surfaces of the four ribs was 42 cm², the side surfaces extending along a projecting direction of the four ribs. The distance X between the ribs adjacent to each other was 1.8 mm, the distance X being measured in a horizontal direction when the second surface of the sample according to Example 1 was inclined to the horizontal plane at 45°. The distance X is a horizontal distance between a center of a proximal end of one of the rib and a center of a distal end of the other rib.

<Example 2>

A sample according to Example 2 was produced in the same manner as in Example 1, except that the interval between the ribs was changed to 10 mm.

<Example 3>

A sample according to Example 3 was produced in the same manner as in Example 1, except that the width of the rib was changed to 1.2 mm. The sum of the areas of the side surfaces extending along the projecting direction of the four ribs was 41 cm$^2$.

<Example 4>

A sample according to Example 4 was produced in the same manner as in Example 1, except for the following points. In the sample according to Example 4, the height (projection length) and the width of each projection were respectively adjusted to 4.8 mm and 9.5 mm. The inclination of the tapered portion of each projection was 3°. The plurality of projections were arranged to make a square lattice in plan view of the first surface. The distance between the projections adjacent to each other was 4 mm. The sum of the areas of the side surfaces extending along the projecting direction of the plurality of projections was 29 cm$^2$. When the second surface was viewed in plan, seven ribs were aligned at an interval of 7 mm along the alignment direction of the projections. Each rib had a height (projection length) of 10 mm and a width of 2 mm. Each rib had a length of about 5 cm. The sum of the areas of the side surfaces extending along the projecting direction of the seven ribs was 71 cm$^2$. The distance X between the ribs adjacent to each other was 4.2 mm, the distance X being measured in the horizontal direction when the second surface of the sample according to Example 1 was inclined to the horizontal plane at 15°. The distance X is a horizontal distance between the center of the proximal end of one rib and the center of the distal end of the other rib.

<Example 5>

A sample according to Example 5 was produced in the same manner as in Example 4, except for the following points. When the second surface was viewed in plan, four ribs were aligned at an interval of 10 mm along the alignment direction of the projections. Each rib had a height (projection length) of 10 mm and a width of 2 mm. Each rib had a length of 5 cm. The sum of the areas of the side surfaces extending along the projecting direction of the four ribs was 42 cm$^2$.

<Example 6>

A sample according to Example 6 was produced in the same manner as in Example 1, except for the following points. When the second surface was viewed in plan, six ribs were aligned with no space therebetween along the alignment direction of the projections. Each rib had a height (projection length) of 8 mm and a width of 8 mm. Each rib was a projecting strip, and a cross-section of the projecting strip in a direction perpendicular to a longitudinal direction of the projecting strip was in the shape of an isosceles triangle. Each rib had a length of 5 cm. The sum of the areas of the side surfaces extending along the projecting direction of the six ribs was 55 cm$^2$.

<Example 7>

A sample according to Example 7 was produced in the same manner as in Example 1, except for the following points. When the second surface was viewed in plan, five ribs were aligned with no space therebetween along the alignment direction of the projections. Each rib was a projecting strip, and a cross-section of the projecting strip in the direction perpendicular to the longitudinal direction of the projecting strip was in the shape of a semicircle having a diameter of 9.5 mm. Each rib had a length of about 5 cm. The sum of the areas of the side surfaces extending along the projecting direction of the five ribs was 41 cm$^2$.

<Example 8>

A sample according to Example 8 was produced in the same manner as in Example 2, except that the inclination of the tapered portion of each projection on the first surface was adjusted to be 22°. The sum of the areas of the side surfaces extending along the projecting direction of the plurality of projections was 15 cm$^2$.

<Example 9>

A sample according to Example 9 was produced in the same manner as in Example 4, except for the following points. The inclination of the tapered portion of each projection on the first surface was adjusted to 45°. The sum of the areas of the side surfaces extending along the projecting direction of the plurality of projections was 5 cm$^2$. When the second surface was viewed in plan, four ribs were aligned at an interval of 10 mm along the alignment direction of the projections. Each rib had a height (projection length) of 10 mm and a width of 2 mm. Each rib had a length of about 5 cm. The sum of the areas of the side surfaces extending along the projecting direction of the four ribs was 42 cm$^2$.

<Comparative Example 1>

A sample according to Comparative Example 1 was produced in the same manner as in Example 1, except that no ribs were provided on the second surface.

<Example 10>

A sample according to Example 10 was produced in the same manner as in Example 1, except that a plurality of truncated square pyramidal ribs were provided on the second surface in the same manner as the plurality of projections on the first surface. Each rib had a height (projection length) of 5 mm and a width of 5 mm. An inclination of the tapered portion of each rib was 3°. Twenty seven ribs were arranged to make a parallelogram lattice in plan view of the second surface. A distance between the ribs adjacent to each other was 6.5 mm. The sum of the areas of the side surfaces extending along the projecting direction of the plurality of ribs was 27 cm$^2$. Each rib was disposed on a straight line where the projection on the first surface was disposed, the straight line extending in a thickness direction of the base.

<Comparative Example 2>

A sample according to Comparative Example 2 was produced in the same manner as in Example 4, except that no ribs were provided on the first surface.

<Example 11>

A sample according to Example 11 was produced in the same manner as in Example 4, except for the following points. When the second surface was viewed in plan, four ribs were aligned at an interval of 12.5 mm along the alignment direction of the projections. Each rib had a height (projection length) of 5 mm and a width of 2 mm. Each rib had a length of about 5 cm. The sum of the areas of the side surfaces extending along the projecting direction of the four ribs was 21 cm$^2$. The distance X between the ribs adjacent to each other was 10.8 mm, the distance X being measured in the horizontal direction when the second surface of the sample according to Comparative Example 2 was inclined to the horizontal plane at 15°. The distance X is a horizontal distance between the center of the proximal end of one rib and the center of the distal end of the other rib.

<Example 12>

A sample according to Example 12 was produced in the same manner as in Example 4, except for the following points. When the second surface was viewed in plan, six ribs were aligned at an interval of 8 mm along the alignment direction of the plurality of projections. Each rib had a height (projection length) of 2 mm and a width of 2 mm. Each rib had a length of about 5 cm. The sum of the areas of the side surfaces extending along the projecting direction of the six ribs was 12 cm$^2$. The distance X between the ribs adjacent to each other was 10.8 mm, the distance X being measured in the horizontal direction when the second surface of the sample according to Example 12 was inclined to the horizontal plane at 15°. The distance X is a horizontal distance between the center of the proximal end of one rib and the center of the distal end of the other rib.

<Comparative Example 3>

A sample according to Comparative Example 3 was produced in the same manner as in Example 8, except that no ribs were provided on the second surface.

<Comparative Example 4>

A sample according to Comparative Example 4 was produced in the same manner as in Example 9, except that no ribs were provided on the second surface.

As shown in Table 1, the transmission loss in the straight direction was 12 dB or more for the samples according to Examples. This indicates that the samples according to Examples attenuate radio waves in the straight direction. This radio wave attenuation is thought to be due to the fact that the plurality of projections on the first surface function as a diffraction grating and cause scattering when a radio wave passes through the samples according to Examples. Moreover, as to the samples according to Examples, the sum S1 of the side surfaces of the ribs is greater than the sum S2 of the side surfaces of the projections; the samples according to Examples 1 to 9 are advantageous in ease of manufacturing by molding. On the other hand, as the samples according to Comparative Examples 1 to 4 are free of ribs, it cannot be said that the samples according to Comparatives Example 1 to 4 are advantageous in ease of manufacturing by molding. Although the sum S1 of the side surfaces of the ribs is equal to or smaller than the sum S2 of the side surfaces of the projections in the samples according to Examples 10 to 12, the samples according to Examples 10 to 12 are thought to be advantageous in ease of manufacturing by molding compared to the samples according to Comparative Examples 1 to 4 which are free of ribs.

Comparison between Examples 1 to 3 and Comparative Example 1 reveals that the transmission loss in the straight direction is increased more by providing the given ribs on the second surface than by providing no ribs. In addition, comparison between Examples 1 to 3 and Example 10 reveals that the transmission loss in the straight direction is increased more by providing the given ribs on the second surface than by providing ribs on the second surface in the same manner as the projections on the first surface.

[Table 2]

| | First surface | | | | |
|---|---|---|---|---|---|
| | Height of projection (projection length) [mm] | Width of projection [mm] | Inclination of tapered portion | Interval between projections [mm] | Angle θ1 |
| Ex. 1 | 5 | 5 | 3° | 6.5 | 45° |
| Ex. 2 | 5 | 5 | 3° | 6.5 | 45° |
| Ex. 3 | 5 | 5 | 3° | 6.5 | 45° |
| Ex. 4 | 4.8 | 9.5 | 3° | 4 | 15° |
| Ex. 5 | 4.8 | 9.5 | 3° | 4 | 15° |
| Ex. 6 | 5 | 5 | 3° | 6.5 | 45° |
| Ex. 7 | 5 | 5 | 3° | 6.5 | 45° |
| Ex. 8 | 5 | 5 | 22° | 6.5 | 44° |
| Ex. 9 | 4.8 | 9.5 | 45° | 4 | 18° |
| Ex. 10 | 5 | 5 | 3° | 6.5 | 45° |
| Ex. 11 | 4.8 | 9.5 | 3° | 4 | 15° |
| Ex. 12 | 4.8 | 9.5 | 3° | 4 | 15° |
| Comp. Ex. 1 | 5 | 5 | 3° | 6.5 | 45° |
| Comp. Ex. 2 | 4.8 | 9.5 | 3° | 4 | 15° |
| Comp. Ex. 3 | 5 | 5 | 22° | 6.5 | 44° |
| Comp. Ex. 4 | 4.8 | 9.5 | 45° | 4 | 18° |

| | Second surface | | | | | | Sum S2 [cm$^2$] of side surfaces of projections | Sum S1 [cm$^2$] of side surfaces of ribs | Transmission loss [dB] in straight direction |
|---|---|---|---|---|---|---|---|---|---|
| | Height of rib (projection length) [mm] | Width of rib [mm] | Shape of rib | Interval between ribs [mm] | Number of ribs | Ratio of distance X to wavelength λ | | | |
| Ex. 1 | 10 | 2 | Plate-shaped | 12.5 | 4 | 0.46 | 27 | 42 | 26 |
| Ex. 2 | 10 | 2 | Plate-shaped | 10 | 4 | 0 | 27 | 42 | 24 |

EP 4 270 047 A1

16

(continued)

| | Second surface | | | | | Ratio of distance X to wavelength λ | Sum S2 [cm²] of side surfaces of projections | Sum S1 [cm²] of side surfaces of ribs | Transmission loss [dB] in straight direction |
|---|---|---|---|---|---|---|---|---|---|
| | Height of rib (projection length) [mm] | Width of rib [mm] | Shape of rib | Interval between ribs [mm] | Number of ribs | | | | |
| Ex. 3 | 10 | 12 | Plate-shaped | 12.5 | 4 | 0.46 | 27 | 41 | 26 |
| Ex. 4 | 10 | 2 | Plate-shaped | 7 | 7 | 107 | 29 | 71 | 15 |
| Ex. 5 | 10 | 2 | Plate-shaped | 10 | 4 | 1.81 | 29 | 42 | 15 |
| Ex. 6 | 8 | 8 | Triangular strip | 0 | 6 | 0 | 27 | 55 | 23 |
| Ex. 7 | 4.75 | 9.5 | Semicircular strip | 0 | 5 | 0 | 27 | 41 | 23 |
| Ex. 8 | 10 | 2 | Plate-shaped | 10 | 4 | 0 | 15 | 42 | 16 |
| Ex. 9 | 10 | 2 | Plate-shaped | 10 | 4 | 107 | 5 | 42 | 12 |
| Ex. 10 | 5 | 5 | Plate-shaped | 6.5 | 27 | - | 27 | 27 | 12 |
| Ex. 11 | 5 | 2 | Plate-shaped | 12.5 | 4 | 2.76 | 29 | 21 | 13 |
| Ex. 12 | 2 | 2 | Plate-shaped | 8 | 6 | 2.76 | 29 | 12 | 14 |
| Comp. Ex. 1 | - | - | - | - | - | - | 27 | - | 18 |
| Comp. Ex. 2 | - | - | - | - | - | - | 29 | - | 8 |
| Comp. Ex. 3 | - | - | - | - | - | - | 15 | - | 10 |

(continued)

| | Second surface | | | | | | Sum S2 [cm²] of side surfaces of projections | Sum S1 [cm²] of side surfaces of ribs | Transmission loss [dB] in straight direction |
|---|---|---|---|---|---|---|---|---|---|
| | Height of rib (projection length) [mm] | Width of rib [mm] | Shape of rib | Interval between ribs [mm] | Number of ribs | Ratio of distance X to wavelength λ | | | |
| Comp. Ex. 4 | - | - | - | - | - | - | 5 | - | 6 |

**Claims**

1. An electromagnetic shield comprising:

a plate-shaped base having a first surface and a second surface, the first surface being configured to allow an electromagnetic wave to be incident on the first surface, the second surface being distant from the first surface and extending along the first surface;
a plurality of first projecting portions projecting from the first surface in a direction away from the second surface; and
a plurality of second projecting portions projecting from the second surface in a direction away from the first surface, wherein
the electromagnetic shield includes a dielectric.

2. The electromagnetic shield according to claim 1, wherein an area of at least one of sides of the second projecting portions is greater than an area of a side surface of the first projecting portion, the side surface extending along a projecting direction of the first projecting portion.

3. The electromagnetic shield according to claim 1 or 2, wherein

the electromagnetic wave has a wavelength $\lambda$,
the first projecting portion is configured to scatter the electromagnetic wave incident on the electromagnetic shield perpendicularly to the first surface such that a radio intensity is strongest in a direction in which the electromagnetic wave scattered forms a first angle with a straight line perpendicular to the first surface, and when the electromagnetic shield is disposed such that the second surface forms the first angle with a horizontal plane, an absolute value of a distance in a horizontal direction between a pair of the second projecting portions adjacent to each other is 0 to $0.5\lambda$ or $(0.95n - 0.2)\lambda$ to $(0.95n + 0.2)\lambda$, where n is an integer of 1 or greater.

4. The electromagnetic shield according to any one of claims 1 to 3, wherein the first projecting portion has a tapered portion.

5. The electromagnetic shield according to any one of claims 1 to 4, wherein the second projecting portion is disposed in relation to the first projecting portion.

6. The electromagnetic shield according to any one of claims 1 to 5, wherein the second projecting portion is disposed at a position where the electromagnetic wave reaches through the first projecting portion.

7. The electromagnetic shield according to any one of claims 1 to 6, wherein

the first projecting portion is configured to scatter the electromagnetic wave incident on the electromagnetic shield perpendicularly to the first surface such that a radio intensity is strongest in a direction in which the electromagnetic wave scattered forms a first angle with a perpendicular straight line perpendicular to the first surface, and
the second projecting portion is disposed at a position where the second projecting portion intersects with a straight line extending through an intersection of the perpendicular straight line and the second surface and forming the first angle with the perpendicular straight line.

8. The electromagnetic shield according to any one of claims 1 to 7, wherein a width of the second projecting portion is smaller than a width of the first projecting portion.

9. The electromagnetic shield according to any one of claims 1 to 8, wherein a projection length of the second projecting portion is longer than a projection length of the first projecting portion.

10. The electromagnetic shield according to any one of claims 1 to 9, wherein a distance between the second projecting portions adjacent to each other in a particular direction when the second projecting portion is viewed in plan along a direction opposite to a projecting direction of the second projecting portion is greater than a distance between the first projecting portions adjacent to each other in the particular direction in plan view of the first surface.

11. The electromagnetic shield according to any one of claims 1 to 10, wherein the electromagnetic shield is free of an electrically conductive portion.

12. The electromagnetic shield according to any one of claims 1 to 11, wherein an imaginary part $\varepsilon''$ of a relative permittivity of the dielectric at at least one frequency in a range of 10 GHz to 300 GHz is 0.1 or less.

13. The electromagnetic shield according to any one of claims 1 to 12, wherein a real part $\varepsilon'$ of a relative permittivity of the dielectric at at least one frequency in a range of 10 GHz to 300 GHz is 2.0 to 4.0.

14. The electromagnetic shield according to any one of claims 1 to 13, wherein

the electromagnetic shield is capable of shielding against an electromagnetic wave with a wavelength $\lambda$, and at least one selected from the group consisting of at least one of projection lengths $p_{1i}$ of the first projecting portions and at least one of projection lengths $p_{2i}$ of the second projecting portions satisfies at least one selected from the group consisting of a requirement $0.25\lambda \le p_{1i} \le 1.3\lambda$ and a requirement $0.25\lambda \le p_{2i} \le 1.3\lambda$.

15. The electromagnetic shield according to any one of claims 1 to 14, wherein

the electromagnetic shield is capable of shielding against an electromagnetic wave with a wavelength $\lambda$, and at least one selected from the group consisting of at least one of widths $w_{1i}$ of the first projecting portions and at least one of widths $w_{2i}$ of the second projecting portions satisfies at least one selected from the group consisting of a requirement $0.51\lambda \le w_{1i} \le 1.6\lambda$ and a requirement $0.51\lambda \le w_{2i} \le 1.6\lambda$.

16. The electromagnetic shield according to any one of claims 1 to 15, wherein

the electromagnetic shield is capable of shielding against an electromagnetic wave with a wavelength $\lambda$, and at least one selected from the group consisting of an interval $i_{1i}$ between the first projecting portions and an interval $i_{2i}$ between the second projecting portions satisfies at least one selected from the group consisting of a requirement $0.51\lambda \le i_{1i} \le 1.6\lambda$ and a requirement $0.51\lambda \le i_{2i} \le 1.6\lambda$.

17. The electromagnetic shield according to any one of claims 1 to 16, wherein at least one selected from the group consisting of the first projecting portion and the second projecting portion has a shape of at least one selected from the group consisting of a circle, a triangle, a quadrilateral, and a polygon having five or more corners in plan view.

18. The electromagnetic shield according to any one of claims 1 to 17, wherein at least one selected from the group consisting of arrangement of the plurality of first projecting portions and arrangement of the plurality of second projecting portions is at least one selected from the group consisting of arrangement at lattice points, arrangement on parallel lines, and random arrangement in plan view.

19. The electromagnetic shield according to any one of claims 1 to 18, wherein

the electromagnetic shield satisfies at least one selected from the group consisting of the following requirements (I) and (II), and
in the following requirements (I) and (II),
$S_{p1}$ is an area of the plurality of first projecting portions measured when the first surface is viewed in plane,
$S_{p2}$ is an area of the plurality of second projecting portions measured when the second surface is viewed in plane,
$S_e$ is an area of the entire electromagnetic shield measured when the first surface is viewed in plan, and
$S_o$ is an area of the entire electromagnetic shield measured when the second surface is viewed in plan:

$$0.2 \le S_{p1}/S_e \le 0.8 \qquad (I);$$

and

$$0.2 \le S_{p2}/S_o \le 0.8 \qquad (II).$$

20. The electromagnetic shield according to any one of claims 1 to 19, wherein

at least one of the electromagnetic shield and the base is a ring-shaped body and has a polygonal or circular outer perimeter when the first surface is viewed along an axis of the ring-shaped body,
the electromagnetic shield further comprises a contact portion configured to be in contact with a component other than the electromagnetic shield, and
the contact portion abuts on the outer perimeter.

21. The electromagnetic shield according to any one of claims 1 to 20, wherein

at least one of the electromagnetic shield and the base is a hollow body whose outer shape is a truncated pyramidal shape, a truncated conical shape, or a truncated elliptical conical shape and which has an opening in each of positions in the outer shape, the positions corresponding to an upper base and a lower base of a truncated pyramid, a truncated cone, or a truncated elliptic cone,
the first surface defines an inner peripheral surface of the hollow body being the electromagnetic shield or the base, and
the second surface defines an outer peripheral surface of the hollow body being the electromagnetic shield or the base.

22. The electromagnetic shield according to claim 21, wherein the plurality of first projecting portions project in a direction perpendicular to the lower base.

FIG. 1

FIG. 2

FIG. 3

1a

32

32

32

10

5

20

2

2

X

2

2

B

θ1

A

FIG. 4

FIG. 5

FIG. 6

FIG.7

FIG.8

FIG.9

FIG.10A

FIG.10B

FIG.10C

## INTERNATIONAL SEARCH REPORT

| International application No. |
| --- |
| **PCT/JP2022/028281** |

| A. | CLASSIFICATION OF SUBJECT MATTER |
| --- | --- |

*G01S 7/03*(2006.01)i; *H01Q 17/00*(2006.01)i; *H05K 9/00*(2006.01)i; *G01S 13/931*(2020.01)n
FI: G01S7/03 220; H01Q17/00; H05K9/00 M; G01S13/931

According to International Patent Classification (IPC) or to both national classification and IPC

| B. | FIELDS SEARCHED |
| --- | --- |

Minimum documentation searched (classification system followed by classification symbols)

G01S 7/00 - G01S 7/42; G01S 13/00 - G01S 13/95; H01Q 15/00 - H01Q 19/32; H05K 9/00

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| X | JP 9-181474 A (FUJI ELECTROCHEMICAL CO LTD) 11 July 1997 (1997-07-11) paragraphs [0001], [0017]-[0028], fig. 12 | 1-2, 4-6, 9-10, 15-19 |
| A | | 3, 7-8, 11-14, 20-22 |
| A | JP 10-190277 A (TOSHIBA IYOU SYST ENG KK) 21 July 1998 (1998-07-21) entire text, all drawings | 1-22 |
| A | JP 63-177500 A (DAIKI SURITSUTAA KOGYO KK) 21 July 1988 (1988-07-21) entire text, all drawings | 1-22 |
| A | JP 4-223399 A (MATSUSHITA ELECTRIC WORKS LTD) 13 August 1992 (1992-08-13) entire text, all drawings | 1-22 |
| A | CN 202652818 U (NEC TOKIN CORP.) 02 January 2013 (2013-01-02) entire text, all drawings | 1-22 |

☐ Further documents are listed in the continuation of Box C.          ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **24 August 2022** | **13 September 2022** |

| Name and mailing address of the ISA/JP | Authorized officer |
| --- | --- |
| **Japan Patent Office (ISA/JP)** <br> **3-4-3 Kasumigaseki, Chiyoda-ku, Tokyo 100-8915** <br> **Japan** | |
| | Telephone No. |

Form PCT/ISA/210 (second sheet) (January 2015)

## INTERNATIONAL SEARCH REPORT
### Information on patent family members

International application No.

**PCT/JP2022/028281**

| Patent document cited in search report | | | Publication date (day/month/year) | Patent family member(s) | Publication date (day/month/year) |
|---|---|---|---|---|---|
| JP | 9-181474 | A | 11 July 1997 | (Family: none) | |
| JP | 10-190277 | A | 21 July 1998 | (Family: none) | |
| JP | 63-177500 | A | 21 July 1988 | (Family: none) | |
| JP | 4-223399 | A | 13 August 1992 | (Family: none) | |
| CN | 202652818 | U | 02 January 2013 | (Family: none) | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004153135 A
- JP 5696781 B
- WO 2021058450 A1